# EUROPÄISCHE PATENTSCHRIFT

(11) **EP 0 833 390 B1**
(45) Veröffentlichungstag und Bekanntmachung des Hinweises auf die Patenterteilung: **07.03.2007**
(21) Anmeldenummer: 97116741.6
(22) Anmeldetag: 25.09.1997
(51) Int. Cl.: H01L 29/744, H01L 29/417

(54) **Kathodenanordnung für GTO-Thyristor**
Cathode arrangement for GTO thyristor
Arrangement de cathode pour thyristor de type GTO

(30) Priorität: 30.09.1996 DE 19640242
(43) Veröffentlichungstag der Anmeldung: 01.04.1998
(73) Patentinhaber: Infineon Technologies AG, 81669 München (DE)
(72) Erfinder: Franz, Günther, Dr.rer.nat., 81929 München (DE); Schuh, Gottfried, 86169 Augsburg (DE)
(74) Vertreter: Patentanwälte Westphal, Mussgnug & Partner

(56) Entgegenhaltungen:
- EP-A- 0 064 614
- EP-A- 0 220 469
- EP-A- 0 355 359
- FR-A- 2 254 879
- US-A- 5 010 384
- PATENT ABSTRACTS OF JAPAN vol. 11, no. 117 (E-498) [2564], 11. April 1987 (1987-04-11) & JP 61 263163 A (MITSUBISHI ELECTRIC CORP), 21. November 1986 (1986-11-21)

## Beschreibung

Die vorliegende Erfindung betrifft eine Kathodenanordnung für einen GTO-Thyristor mit einer auf eine Basisschicht aufgebrachten Emitterzone, die planar in die Basisschicht eingebettet ist, einer die Basisschicht kontaktierenden Gate-Elektrode, einer auf der Emitterzone vorgesehenen Emitterelektrode, die wenigstens eine Metallschicht aufweist, und einer Metalldruckplatte, welche auf die Oberfläche der Ermitterelektrode aufgesetzt ist, wobei die Oberfläche der Emitterelektrode wenigstens 10 µm über der Oberfläche der Emitterzone gelegen ist, so daß die Unterseite der Metalldruckplatte in einem Abstand von der Oberseite der Gateelektrode verläuft.

In der Halbleitertechnik wird bekanntlich allgemein die Isolation verschiedener Potentiale auf der Oberfläche eines Halbleiterkörpers durch laterale Trennung mittels beispielsweise Gräben oder bei Überkreuzungen von Leiterbahnen durch Mehrlagenmetallisierung unter Verwendung von Zwischenisolierschichten bewirkt. Diese an sich üblichen Isolationsmöglichkeiten sind bei Halbleiter-Leistungsbauelementen, die einen Druckkontakt mit einem planaren, durchgehenden Druckstück verwenden, nur bedingt anwendbar: wird nämlich dieses planare durchgehende Druckstück auf die mit Elektroden versehenen Oberfläche des Halbleiterkörpers aufgesetzt, so sind in Folge der äußerst geringen Höhenunterschiede der Elektroden Kurzschlüsse und/oder Nicht-Kontaktierungen zu befürchten.

Aus diesem Grund werden bei Halbleiter-Leistungsbauelementen, wie beispielsweise GTO-Thyristoren, durch Isolieren von Potentialebenen mittels Versenkung von Metallstrukturen in Gräben des Halbleiterkörpers von anderen Potentialebenen isoliert. Ein Beispiel hierfür zeigt die US-A-5,010,384, bei der eine Emitterzone mesaartig die Ebene einer Basisschicht überragt, wobei auf der Emitterzone und der Basisschicht jeweils eine Emitterelektrode und eine Gate-Elektrode aufgetragen sind. Die Emitterelektrode liegt aber in Folge der mesaartigen Struktur erheblich über dem Höhenniveau der Gate-Elektrode, so dass ein die Emitterelektrode kontaktierendes Druckstück keinesfalls in Berührung mit der darunter liegenden Gate-Elektrode kommen kann. Zusätzlich ist es aus der US-A-5,010,384 noch bekannt, zwischen Emitterelektrode und Emitterzone eine Widerstandsschicht vorzusehen, die direkt auf der Emitterzone gelegen ist.

In der FR 2 254 879 wird ein Herstellungsverfahren für Leistungshalbleiter mit Presskontakten beschrieben, bei denen die elektrischen Kontaktmittel zwischen der Halbleiterscheibe und aus mehr oder weniger elastisch durch das Gehäuse oder einen Kühlkörper gegen die Halbleiterscheibe gedrückten Metallkontakten gebildet werden.

Die EP 0 220 469 A1 beschreibt eine GTO-Thyristoranordnung, bei der auch Druckkontakte eingesetzt werden können.

Bei der Herstellung derartiger bekannter GTO-Thyristoren und auch anderer Druckkontakt-Leistungsbauelemente wird im Verlauf der Diffusionsprozesse zur Bildung der Mesastrukturen in den aus Silizium bestehenden Halbleiterkörper ein Graben durch Ätzen eingebracht, der etwa 25 mu m tief ist. Derartige Gräben werden in Zeilen- und Spaltenrichtungen vorgesehen, so dass einzelne Mesastrukturen in einem Schachbrett-Muster zurückbleiben. Das Eindringen der Gräben geschieht vorzugsweise durch nasschemische Ätzverfahren, wobei aber auch grundsätzlich Trockenätzverfahren an sich möglich sind. Nach Aufbringung von Isolationsschichten werden sodann in üblicher Weise Kontaktfenster geöffnet, Metallschichten aufgebracht und auf photolitographischem Wege derart strukturiert, dass eine Metallschicht-Ebene auf den Mesastrukturen und eine andere Metallebene im Bereich des später vorgesehenen Druckstückes ausschließlich in den Gräben verlaufen. Zusätzlich werden zur Vervollständigung der Isolierung die Metallschichten in den Gräben mit Isolationsschichten bedeckt, die aber von dem Druckstück nicht berührt werden.

Die im Verlauf der Diffusionsprozesse geätzten Mesastrukturen erfordern bei nachfolgenden Photolitographieschritten spezielle Technologien, welche gewährleisten, daß einerseits die steilen Kanten der Gräben zuverlässig mit Photolack bedeckt werden, und daß andererseits der Photolack nur so dick aufgetragen wird, daß ein sicheres Durchbelichten gewährleistet ist. Diese beiden Forderungen laufen einander entgegen und sind daher nur bedingt erfüllbar. Aus diesem Grund liegt bei den bekannten GTO-Thyristoren eine relative hohe Defektdichte vor, was auch einen relativ großen Nacharbeitanteil bei den einzelnen Phototechniken nach sich zieht.

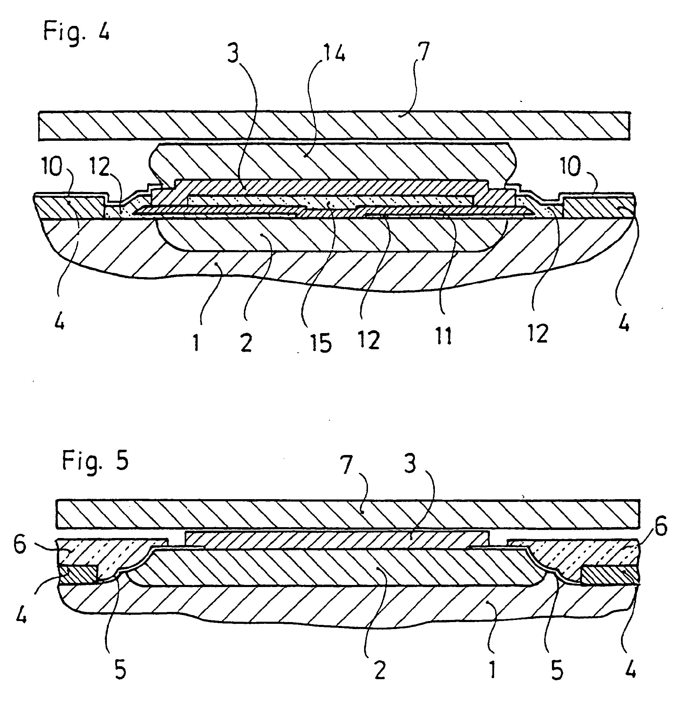

Figur 5 zeigt eine herkömmliche Kathodenanordnung für einen GTO-Thyristor. Bei dieser Kathodenanordnung ist auf einer p-Basisschicht 1 in einer mesaartigen Struktur eine n-Emitterzone 2 vorgesehen, auf welcher sich eine Emitter- beziehungsweise Kathodenelektrode 3 befindet. Die p-Basisschicht 1 ist durch Gate-Elektroden 4 kontaktiert. Die Seitenflächen der Mesastruktur der Emitterzone 2 und des tiefer benachbarten Randes der p-Basisschicht 1 sind durch eine Siliziumoxid/Siliziumnitrid-Passivierungsschicht 5 abgedeckt. Außerdem ist zur elektrischen Isolierung noch eine Polyimidschicht 6 auf diesen Randbereichen der Mesastruktur aufgetragen. Die Kontaktgabe zu der Emitterelektrode 3 erfolgt über eine beispielsweise aus Molybdän bestehende Druckplatte 7, die sich auch über benachbarte GTO-Thyristoren beziehungsweise deren Emitterelektroden erstrecken kann, wenn diese GTO-Thyristoren alle parallel zueinander geschaltet sind.

Wie oben bereits erläutert wurde, ist die Herstellung der Mesastrukturen mit sich einander widersprechenden Forderungen verknüpft, so daß die bekannten GTO-Thyristoren nicht mit der gewünscht hohen Ausbeute herstellbar sind.

Es ist Aufgabe der vorliegenden Erfindung, eine Kathodenanordnung für GTO-Thyristoren zu schaffen, bei der eine Einstellung des Widerstandswertes einer Widerstandsschicht in einem relativ weiten Bereich erreicht werden kann.

Diese Aufgabe wird durch eine Kathodenanordnung mit den Merkmalen des Anspruchs 1 gelöst. Eine vorteilhafte Weiterbildung ist Gegenstand des Unteranspruchs 2.

Zwischen der Emitterzone und der Emitterelektrode ist eine Widerstandsschicht vorgesehen. Diese verläuft aber nicht "senkrecht" in einem Stapel der einzelnen Schichten, sondern vielmehr lateral, so daß sie sich von der Mitte der Oberfläche der Emitterzone auf einem Isolierfilm seitlich zum Rand der Emitterzone erstreckt und nur dort die Emitterelektrode kontaktiert. Für diese Widerstandsschicht können beispielsweise polykristallines Silizium oder Polysilizid verwendet werden.

Es ist möglich, die Emitterelektrode aus einer galvanisch abgeschiedenen Metallschicht so dick auszubilden, daß die erwähnte Höhendifferenz zwischen der Oberfläche der Emitterelektrode und der Oberfläche der Emitterzone von etwa 10 - 15 µm erreicht wird. Für diese Metallschicht kann beispielsweise eine Nikkel/Gold-Galvanikschicht vorgesehen werden.

Weiterhin können die Emitterelektrode und/oder die Gate-Elektrode aus Aluminium oder einer Schichtenfolge aus Titan, Platin und Gold bestehen. Vorzugsweise werden beide Elektroden, also die Emitterelektrode und die Gate-Elektrode jeweils aus dem gleichen Material hergestellt.

Die bereits erwähnte Nickel/Gold-Galvanikschicht, die für die Emitterelektrode verwendet werden kann, kann beispielsweise aus einer 10 - 25 µm, vorzugsweise 15 - 20 µm dicken Nickelschicht und einer darauf vorgesehenen Goldschicht mit einer Schichtdicke unter 1 µm bestehen.

Zusammenfassend zeichnet sich die erfindungsgemäße Kathodenanordnung für GTO-Thyristoren also dadurch aus, daß eine Widerstandsschicht lateral zwischen Emitterzone und Emitterelektrode vorgesehen ist.

Nachfolgend wird die Erfindung anhand der Zeichnungen näher erläutert. Diese zeigen:
- Figur 1: einen Schnitt durch die Kathodenanordnung eines GTO-Thyristors, die nicht Bestandteil der vorliegenden Erfindung ist,
- Figur 2: einen Schnitt durch die Kathodenanordnung eines GTO-Thyristors nach einem ersten Ausführungsbeispiel,
- Figur 3: einen Schnitt durch die Kathodenanordnung eines GTO-Thyristors, die nicht Bestandteil der vorliegenden Erfindung ist.
- Figur 4: einen Schnitt durch die Kathodenanordnung eines GTO-Thyristors nach einem zweiten Ausführungsbeispiel der Erfindung und
- Figur 5: einen Schnitt durch eine herkömmliche Kathodenanordnung eines GTO-Thyristors.

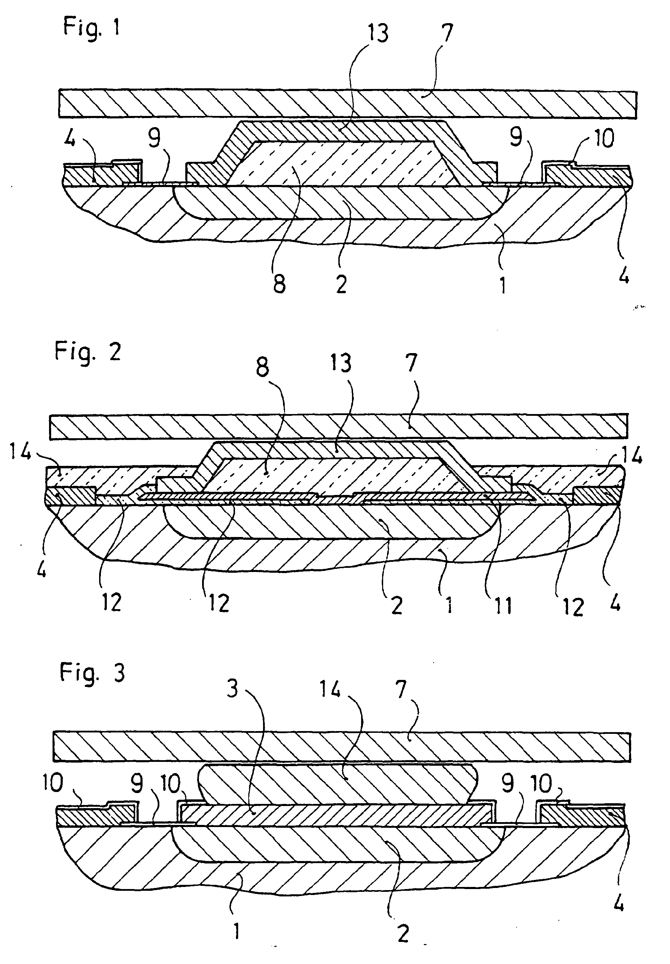

Die Figur 5 ist bereits eingangs erläutert worden. In den Figuren 1 bis 4 werden für einander entsprechende Bauteile die gleichen Bezugszeichen wie in Figur 5 verwendet.

Die in Figur 1 dargestellte Kathodenanordnung, die nicht Bestandteil der vorliegenden Erfindung ist, hat eine Planarstruktur, bei der die Emitterzone 2 in die p-Basisschicht 1 eingebettet ist. Auf der Emitterzone 2 befindet sich eine Isolatorschicht 8 aus beispielsweise Siliziumdioxid, die durch chemische Dampfabscheidung (CVD) aufgetragen ist. Anstelle von Siliziumdioxid können aber auch Kunststoffe oder Mehrschichtstrukturen verwendet werden. Von Bedeutung ist dabei, daß bei diesen Isolatorschichten an den Grenzflächen keine oder möglichst wenig Ladungen angesammelt werden. Auf der Isolatorschicht 8 ist eine Emitterelektrode 13 aufgetragen, die am Rand der Isolatorschicht 8 die Emitterzone 2 kontaktiert. Diese Emitterelektrode 13 wird sodann mit der Druckplatte 7 mit Druck beaufschlagt, wobei diese Druckplatte 7 beispielsweise aus Molybdän bestehen kann.

Der Abstand zwischen der Oberseite der Emitterelektrode 13 und der Oberfläche der Emitterzone 2 beträgt etwa 10 bis 15 µm, wobei aber auch größere Abstände gewählt werden können. Dadurch ist gewährleistet, daß die Unterseite der die Oberfläche der Emitterelektrode 13 mit Druck beaufschlagenden Metalldruckplatten 7 in Abstand von der Oberseite der Gate-Elektrode 4 angeordnet ist.

Der an die Oberfläche des Halbleiterkörpers tretende pn-Übergang zwischen der p-Basisschicht 1 und der Emitterzone 2 ist durch eine Isolatorschicht 9 aus beispielsweise Siliziumdioxid abgedeckt. Ebenso kann die Oberfläche der Gate-Elektrode 4 mit einer Gate-Isolationsschicht 10 aus beispielsweise Siliziumdioxid überzogen sein, um weiter die elektrische Isolation zu der Druckplatte 7 zu verbessern.

Figur 2 zeigt ein Ausführungsbeispiel der erfindungsgemäßen Kathodenanordnung, bei dem zwischen der Emitterelektrode 13 und dem Mittenbereich der Oberfläche der Emitterzone 2 eine Widerstandsschicht 11 aus beispielsweise polykristallinem Silizium oder Polysilizid vorgesehen ist. Diese Widerstandsschicht 11 verläuft lateral von dem Mittenbereich der Emitterzone 2 auf einer Isolatorschicht 12 aus beispielsweise Siliziumdioxid. Außerdem ist zur Verbesserung der Isolation noch eine dicke Gate-Isolationsschicht 14 auf den Gate-Elektroden 4 vorgesehen.

Wesentlich an dem Ausführungsbeispiel von Figur 2 mit der Widerstandsschicht 11 ist, daß diese Widerstandsschicht 11 im Gegensatz zum Stand der Technik, wie dieser oben erläutert ist, lateral geführt ist und nicht stapelartig auf der Emitterzone 2 angeordnet ist. Dadurch kann eine Einstellung des Widerstandswertes der Widerstandsschicht 11 in einem relativ weiten Bereich erreicht werden.

Figur 3 zeigt eine Kathodenanordnung, die nicht Bestandteil der vorliegenden Erfindung ist, bei dem die notwendige "Höhe" der Emitterelektrode 3 durch deren Verstärkung mittels einer galvanisch aufgebrachten Nickel/Gold-Galvanikschicht 14 erreicht ist. Anstelle dieser Nickel/Gold-Galvanikschicht kann gegebenenfalls auch ein anderes Material verwendet werden, sofern dieses geeignet ist, den erforderlichen Abstand zwischen der Unterseite der Druckplatte 7 und der Oberseite der Gate-Elektroden 4 zu gewährleisten.

In der Kathodenanordnung von Figur 3 ist der Rand der Emitterelektrode 3 mit der Isolationsschicht 10 abgedeckt, da diese Emitterelektrode 3 in zweckmäßiger Weise gemeinsam mit den Gate-Elektroden 4 hergestellt und aus dem gleichen Material, wie beispielsweise Aluminium, besteht. In diese Isolationsschicht 10 wird sodann oberhalb der Emitterelektrode 3 ein Fenster eingebracht, in welchem sodann die Galvanikschicht 14 aufwächst, während die restlichen Aluminiumflächen während der Galvanik durch die Isolationsschicht 10 abgedeckt bleiben.

Figur 4 zeigt schließlich ein anderes Ausführungsbeispiel der Erfindung, bei dem die Galvanikschicht 14 im Zusammenhang mit einer Widerstandsschicht 11 auf der Emitterelektrode 3 aufgebracht ist. Damit bei diesem Ausführungsbeispiel diese Widerstandsschicht 11 "lateral" wirkt, befindet sich stapelartig auf der Widerstandsschicht 11 noch eine Isolationsschicht 15 aus beispielsweise Siliziumdioxid.

Die Nickel/Gold-Galvanikschicht 14 der Kathodenanordnungen der Figuren 3 und 4 kann aus einer 10 - 25 µm, vorzugsweise 15 - 20 µm dicken Nickelschicht und einer darauf vorgesehenen Goldschicht mit einer Schichtdicke unter 1 µm bestehen. Weiterhin kann für die Gate-Elektrode 4 und die Emitterelektrode 3 beziehungsweise 13 anstelle von Aluminium auch eine Schichtenfolge aus Titan, Platin und Gold herangezogen werden. Selbstverständlich sind für die obigen Schichten jedoch auch andere Materialien geeignet.

## Patentansprüche

1. Kathodenanordnung für GTO-Thyristor mit einer auf eine Basisschicht (1) aufgebrachten Emitterzone (2), die planar in die Bassischicht (1) eingebettet ist, einer die Basisschicht (1) kontaktierenden Gate-Elektrode (4), einer auf der Emitterzone (2) vorgesehenen Emitterelektrode (13), die wenigstens eine Metallschicht aufweist, und einer Metalldruckplatte (7), welche auf die Oberfläche der Emitterelektrode (13) aufgesetzt ist, wobei die Oberfläche der Emitterelektrode (13) wenigstens 10 µm über der Oberfläche der Emitterzone (2) gelegen ist, so dass die Unterseite der Metalldruckplatte (7) im Abstand von der Oberseite der Gate-Elektrode (4) verläuft, und zwischen der Emitterzone (2) und der Emitterelektrode (13) eine Widerstandsschicht (11) liegt, wobei die Widerstandschicht (11) den Mittenbereich der Oberfläche der Emitterzone kontaktiert, die Widerstandsschicht (11) von dem Mittenbereich der Oberfläche der Emitterzone (2) lateral auf einem Isolierfilm (12) zum Rand der Emitterzone (2) verläuft und die Widerstandsschicht (11) nur am Rand der Emitterzone die Emitterelektrode (13) kontaktiert.

2. Kathodenanordnung nach Anspruch 1,
**dadurch gekennzeichnet,**
**dass** die Widerstandsschicht (11) eine Polysilizid-Schicht ist.

## Claims

1. Cathode arrangement for a GTO thyristor comprising an emitter zone (2), which is applied to a base layer (1) and is embedded into the base layer (1) in planar fashion, a gate electrode (4), which makes contact with the base layer (1), an emitter electrode (13), which is provided on the emitter zone (2) and has at least one metal layer, and a metal pressure plate (7), which is placed onto the surface of the emitter electrode (13), the surface of the emitter electrode (13) being located at least 10 µm above the surface of the emitter zone (2), with the result that the underside of the metal pressure plate (7) runs at a distance from the top side of the gate electrode (4), and a resistance layer (11) lying between the emitter zone (2) and the emitter electrode (13), the resistance layer (11) making contact with the central region of the surface of the emitter zone, the resistance layer (11) running from the central region of the surface of the emitter zone (2) laterally on an insulating film (12) to the edge of the emitter zone (2), and the resistance layer (11) making contact with the emitter electrode (13) only at the edge of the emitter zone.

2. Cathode arrangement according to claim 1,
**characterized**
**in that** the resistance layer (11) is a polysilicide layer.

## Revendications

1. Arrangement de cathode pour un thyristor GTO comprenant une zone d'émetteur (2) appliquée sur une couche de base (1) et noyée de façon planaire dans la couche de base (1), une électrode barrière (4) reliée à la couche de base (1), une électrode d'émetteur (13) prévue sur la zone d'émetteur (2), qui présente au moins une couche métallique, et une plaque à pression métallique (7) placée sur la surface de l'électrode d'émetteur (13), la surface de l'électrode d'émetteur (13) se situant au moins 10 µm au-dessus de la surface de la zone d'émetteur (2) de sorte que la face inférieure de la plaque à pression métallique (7) s'étende à une distance de la face supérieure de l'électrode barrière (4), et une couche résistive (11) étant située entre la zone d'émetteur (2) et l'électrode d'émetteur (13), la couche résistive (11) contactant la zone centrale de la surface de la zone d'émetteur, la couche résistive (11) s'étendant de la zone centrale de la surface de la zone d'émetteur (2) latéralement sur une feuille d'isolation (12) vers le bord de la zone d'émetteur (2), et la couche résistive (11) ne contactant l'électrode d'émetteur (13) que sur le bord de la zone d'émetteur.

2. Arrangement de cathode selon la revendication 1,
**caractérisé en ce que**
la couche résistive (11) est une couche en polysiliciure.
